# EUROPÄISCHE PATENTSCHRIFT

(11) **EP 2 057 538 B1**
(45) Veröffentlichungstag und Bekanntmachung des Hinweises auf die Patenterteilung: **13.01.2010**
(21) Anmeldenummer: 07802832.1
(22) Anmeldetag: 23.08.2007
(51) Int. Cl.: G06F 9/44

(54) **VERFAHREN ZUR ERZEUGUNG EINES GRÖSSENOPTIMIERTEN DELTA-FILES**
METHOD FOR PRODUCING A SIZE-OPTIMIZED DELTA FILE
PROCÉDÉ POUR GÉNÉRER UN FICHIER DELTA DE TAILLE OPTIMISÉE

(30) Priorität: 29.08.2006 DE 102006040395
(43) Veröffentlichungstag der Anmeldung: 13.05.2009
(73) Patentinhaber: SIEMENS AKTIENGESELLSCHAFT, 80333 München (DE)
(72) Erfinder: LAUTHER, Ulrich, 80686 München (DE)
(86) Internationale Anmeldenummer: PCT/EP2007/058775
(87) Internationale Veröffentlichungsnummer: WO 2008/025719

(56) Entgegenhaltungen:
- EP-A- 1 501 196
- US-A1- 2006 039 618
- US-A1- 2006 107 260

## Beschreibung

Heutzutage ist es oftmals notwendig, Software oder Betriebsdaten zum Ausführen einer Applikation oder zum Betreiben von Geräten, wie beispielsweise Mobilfunkgeräte oder auf Fahrzeugen mitgeführte, automatische Mauterfassungseinrichtungen, zu ändern, um hierdurch beispielsweise Fehler zu beheben und verbesserte oder weitere Funktionen zu implementieren ("Software-Upgrade" oder "Software-Update").

Insbesondere für den Fall, dass die aktuelle Version der Software oder Betriebsdaten über eine Schnittstelle mit vergleichsweise langsamer und/oder teurer Datenübertragung (beispielsweise eine Luftschnittstelle im Mobilfunk) übertragen werden soll, ist es unter Umständen sinnvoll, nicht den kompletten Datensatz zu übertragen, sondern eine andere Vorgehensweise zu wählen, bei der lediglich die "Differenz" zwischen der älteren Version und der jüngeren Version übertragen wird, und anschließend mithilfe der übertragenen Differenz die jüngere Version aus der schon vorhandenen älteren Version generiert wird.

Zu diesem Zweck ist beispielsweise aus dem US-Patent Nr. 6,401,239 die Erzeugung eines Delta-Files durch einen Delta-File-Generator eines ersten Computers (Server) bekannt. Der Delta-File, welcher die Differenz zwischen der ersten Version und der zweiten Version eines Datenfiles kodiert, wird an einen zweiten Computer (Client) übertragen, auf dem die erste Version des Datenfiles gespeichert ist, wobei mittels einer Wiederherstellungseinrichtung die zweite Version des Datenfiles aus dessen erster Version und dem Delta-File generiert wird.

Ein zentrales Problem hierbei ist die Erzeugung eines Delta-Files möglichst geringer Größe, um hierdurch die zur Übertragung des Delta-Files notwendige Übertragungszeit beziehungsweise die hierbei verursachten Übertragungskosten zu minimieren.

Die Erzeugung eines Delta-Files ist beispielsweise in Walter F. Tichy, "The String-to-String Correction Problem with Block Moves", ACM Trans. on Computer Systems, Vol. 2, No. 4, Nov. 1984, Seiten 309-321, beschrieben.

Das Dokument US 2006/0107260 A1 offenbart ein Verfahren zur Erzeugung eines die Differenz zwischen einem ersten Datenfile und einem zweiten Datenfile kodierenden Delta-Files, bei welchem Verfahren eine Menge von in den beiden Datenfiles in teilweiser Übereinstimmung vorhandenen Teildatenstrings bestimmt und ein Graph modelliert wird, bei dem jeder Netzknoten einen auf dem ersten Datenfile basierenden Datenverarbeitungsschritt repräsentiert, bei welchem Verfahren ein Delta-File generiert wird, welcher eine Abfolge von Datenverarbeitungsschritten und deren Datenfelder enthält.

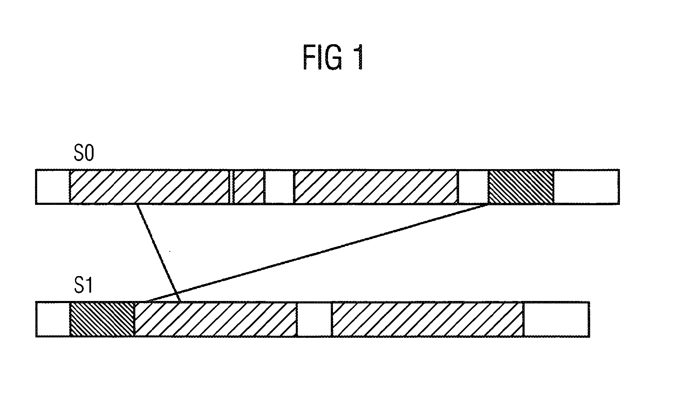

Zur Erläuterung des dort beschriebenen Verfahrens wird Bezug auf Fig. 1 genommen. Demnach werden zwei verschiedene Datenfiles, von denen der eine (beispielsweise eine jüngere Version eines Datenfiles) aus dem anderen (beispielsweise eine ältere Version des Datenfiles) mittels eines Delta-Files generiert werden soll, als zwei Datenstrings, S0 und S1 bezeichnet, aufgefasst. Um einen Delta-File zu erzeugen, wird zunächst eine Menge nicht-überlappender, maximaler (exakter) "Matches" gesucht, das heißt Teildatenstrings mit identischen Zeichen und maximaler Länge, die sowohl in S0 als auch in Sl, wenn auch an unterschiedlichen Positionen der jeweiligen Datenstrings, auftreten.

Das Ergebnis ist eine Folge von Matches und Lücken, welche beispielhaft in Fig. 1 für S1 (in Fig. 1 oben) und für S0 (in Fig. 1 unten) dargestellt ist. Durch die beiden in Fig. 1 eingezeichneten Pfeile sind als Beispiel zwei exakt matchende Teildatenstrings gekennzeichnet.

Anschließend wird auf Basis der gefundenen, exakt übereinstimmenden Teildatenstrings ein Delta-File generiert, welcher aus einer Folge an dem ersten Datenfile S0 sukzessiv durchzuführender Datenverarbeitungsschritte (Operationen oder Befehle) besteht, hier COPY- und ADD-Operationen, wobei eine COPY-Operation jeweils aus den exakt übereinstimmenden Datenbereichen und eine ADD-Operation jeweils aus den zwischen den exakt übereinstimmenden Datenbereichen befindlichen Lücken resultiert.

Ein COPY-Befehl, welcher in dem dargestellten Beispiel typischer Weise die Syntax "COPY <Länge> <Offset in S0> <Offset in S1>" hat, bewirkt ein Kopieren eines exakt übereinstimmenden Datenbereichs, welcher sich in dem Datenstring S0 an der Position <Offset in S0> befindet und die Länge <Länge> hat, nach S1 und zwar an der Position <Offset in S1>. Andererseits bewirkt ein ADD-Befehl, welcher typischer Weise die Syntax "ADD <Länge> <Daten von Sl>" aufweist, ein Hinzufügen von Daten der Länge <Länge>, welche im Delta-File mitgeführt werden müssen, in die Lücken zwischen den exakt übereinstimmenden Datenbereichen in S1. Auf diese Weise kann der zweite Datenfile S1 durch "Abarbeiten" der sukzessiven Folge von COPY- und ADD-Operationen aus dem ersten Datenfile generiert werden.

Bei dem dargestellten Verfahren bestimmt sich aus der Größe der exakt übereinstimmenden Datenbereiche die Größe des Delta-Files, wobei größere Matches das Volumen der im Delta-File zu transportierenden Daten verringern. Die Berechnung einer Überdeckung mit maximalen Matches kann heutzutage mithilfe moderner Datenstrukturen, wie sie beispielsweise aus der Bioinformatik zur Berechnung sehr langer DNA-Stränge bekannt sind, in sehr effizienter Weise erfolgen. Der erzeugte Delta-File wird vor einer Übertragung typischer Weise komprimiert und vor dem Update- bzw. Upgrade-Prozess dekomprimiert.

Das aufgezeigte Verfahren hat den Nachteil, dass unter Umständen sehr viele sukzessiv abzuarbeitende Datenverarbeitungsschritte im Delta-File enthalten sein müssen, um einen zweiten Datenfile aus einem ersten Datenfile zu generieren.

Dieser Nachteil kann behoben werden, wenn anstatt mit in den beiden Datenfiles exakt übereinstimmenden Teildatenbereichen mit lediglich annähernd gleichen beziehungsweise gering voneinander verschiedenen Datenbereichen, so genannten "Pseudo-Matches" gearbeitet wird.

In diesem Fall wird in einem Delta-File für jedes Pseudo-Match Byte-weise die Differenz der gering unterschiedlichen Teildatenbereiche gespeichert, wobei die Differenz-Bytes, welche sich aus den exakt übereinstimmenden Daten eines Pseudo-Matches ergeben, Null sind, während die Differenz-Bytes, welche aus den voneinander verschiedenen Daten eines Pseudo-Matches resultieren, im Allgemeinen von Null verschieden sind. Die Differenz für einen Pseudo-Match besteht weitgehend aus Nullen (Null-Bytes) und ist somit hoch komprimierbar.

Auf Basis der ermittelten pseudo-matchenden Teildatenstrings wird im Anschluss daran ein Delta-File generiert, welcher aus einer Folge von sukzessiv am ersten Datenfile durchzuführenden Datenverarbeitungsschritten besteht, nämlich DIFF- und ADD-Operationen, wobei eine DIFF-Operation jeweils aus den annähernd übereinstimmenden Datenbereichen und ein ADD-Befehl jeweils aus den zwischen diesen befindlichen Lücken resultiert.

Ein DIFF-Befehl bewirkt durch Byte-weise Addition seiner Bytes zu den entsprechenden Werten im ersten Datenfile bei Vorliegen eines Null-Bytes in der Differenz ein Kopieren von Daten des ersten Datenfiles (von der dem Null-Byte entsprechenden Position des ersten Datenfiles an die entsprechende Position des zweiten Datenfiles) und bei Vorliegen eines Nicht-Null-Bytes ein Kopieren der Summe aus dem Byte des ersten Datenfiles und der Daten aus dem DIFF-Befehl an die entsprechende Position in dem zweiten Datenfile.

Im Vergleich zu Delta-Files, welche auf exakt übereinstimmenden Datenbereichen (Matches) beruhen, kann durch die Verwendung von nur annähernd übereinstimmenden Datenbereichen (Pseudo-Matches) die Anzahl der Pseudo-Matches und damit die Anzahl der im Delta-File zu übertragenden Datenverarbeitungsoperationen deutlich reduziert werden.

Die Verwendung von Pseudo-Matches kann dem Programmcode des frei verfügbaren Software-Tools "bsdiff" entnommen werden, welcher jedoch nicht weiters dokumentiert ist.

Grundsätzlich ist bei der Verwendung von Pseudo-Matches ein Trade-off zwischen wenigen langen Pseudo-Matches mit vielen Nicht-Null-Bytes und vielen kurzen Pseudo-Matches mit wenigen Nicht-Null-Bytes zu finden. Während der erst genannte Fall für die Datenkompression schlechter ist, ist er in Hinblick auf die geringere Menge an Datenverarbeitungsbefehlen vorteilhaft. Andererseits ist der letzt genannte Fall für die Datenkompression besser, während er nachteilig in Hinblick auf die größere Menge an Datenverarbeitungsbefehlen ist.

Demnach liegt bei der Erzeugung von auf Pseudo-Matches basierenden Delta-Files ein Optimierungsproblem vor, das die Auswahl der zu verwendenden Matches und ihre Zusammenfassung zu Pseudo-Matches zum Gegenstand hat. In dem oben erwähnten Software-Tool bsdiff wird zu diesem Zweck eine kaum durchschaubare Heuristik eingesetzt.

Die Aufgabe der vorliegenden Erfindung liegt darin, ein Verfahren zur Erzeugung eines Delta-Files anzugeben, mit welchem eine Optimierung der Größe (Datenvolumen) des Delta-Files erreicht werden kann.

Diese Aufgabe wird nach dem Vorschlag der Erfindung durch ein Verfahren zur Erzeugung eines Delta-Files mit den Merkmalen von Anspruch 1 gelöst. Vorteilhafte Ausgestaltungen der Erfindung sind durch die Merkmale der Unteransprüche angegeben.

Erfindungsgemäß ist ein Verfahren zur Erzeugung eines die Differenz zwischen einem ersten Datenfile und einem zweiten Datenfile kodierenden Delta-Files (Delta-Patch) gezeigt, wobei die beiden Datenfiles jeweils als Datenstrings (Datensequenzen) aufgefasst werden.

In dem erfindungsgemäßen Verfahren wird zunächst eine Menge von in den beiden Datenfiles in teilweiser Übereinstimmung vorhandenen Datenteilstrings ("Pseudo-Matches") bestimmt und auf Basis der Pseudo-Matches der Delta-File generiert. Die Grundidee des erfindungsgemäßen Verfahrens besteht nun darin, dass im Rahmen der Graphentheorie ein Netzwerk (Graph) mit Netzknoten und die Netzknoten verbindenden Netzkanten modelliert wird, wobei jeder Netzknoten einen "Zustand" eines Datenbytes der sukzessiven Anordnung von Datenbytes des zweiten Datenfiles repräsentiert. Zudem wird jeder einem Datenbyte zugeordnete Netzknoten mit allen Netznoten, welche einem unmittelbar vorangehenden Datenbyte zugeordnet sind, durch Netzkanten verbunden. Durch die Zuweisung von Kostenwerten zu den Netzknoten und Netzkanten kann durch Verbinden der Netzknoten mit Quelle und Senke ein kostenoptimierender Pfad durch das Netzwerk ermittelt werden, welcher in der Übertragung auf die zugeordneten Zustände der Datenbytes des zweiten Datenfiles einem größenoptimierten Delta-File entspricht. Vorteilhaft wird der Delta-File anschließend komprimiert.

"Zustände" von Datenbytes sind mögliche, auf Datenbytes des ersten Datenfiles basierende Datenverarbeitungsschritte (Operationen oder Befehle), welche in Verbindung mit zu den Datenverarbeitungsschritten gehörenden Datenfeldern der Erzeugung von Datenbytes des zweiten Datenfiles dienen. Solche Datenverarbeitungsschritte können beispielsweise
"ADD-Operationen " und jeweils auf einen Pseudo-Match bezogene "DIFF-Operationen" sein. Die ADD-Operation bewirkt hierbei das Lesen des zugehörigen Datenbytes aus dem Delta-File (Input) und dessen Speichern an der laufenden Position im zweiten Datenfile, die anschließend aktualisiert wird. Anders ausgedrückt, bewirkt die ADD-Operation das Lesen eines dieser ADD-Operation zugeordneten Datenfeldes aus dem Delta-File und dessen Speichern an einer Position im zweiten Datenfile, welche der Position des Datenbytes entspricht, dem die ADD-Operation zugeordnet ist. Die jeweils auf einen verschiedenen Pseudo-Match bezogenen DIFF-Operationen bewirken ein Speichern einer der jeweiligen Verwendung des Pseudo-Matches entsprechenden Byte-weisen Summe der Datenbytes (aus dem ersten Datenfile und Dateninhalt des DIFF-Befehls) an der laufenden Position im zweiten Datenfile. Anders ausgedrückt, bewirkt die auf ein Pseudo-Match bezogene DIFF-Operation ein Speichern eines Summen-Datenbytes, summiert aus einem Datenfeld (Byte) der DIFF-Operation und einem entsprechenden Datenbyte des Pseudo-Matches des ersten Datenfiles, an einer Position im zweiten Datenfile, welche der Position des Datenbytes entspricht, dem die DIFF-Operation zugeordnet ist. Um die verschiedenen Zustände der Datenbytes des zweiten Datenfiles als Netzknoten modellieren zu können, werden mögliche Datenverarbeitungsschritte (insbesondere alle) zur Erzeugung von Datenbytes des zweiten Datenfiles auf Basis von Datenbytes des ersten Datenfiles ermittelt. Besonders vorteilhaft werden die Datenverarbeitungsschritte, wie DIFF-Operationen, auf Pseudo-Matches bezogen.

Bei einer vorteilhaften Art und Weise der Modellierung des Graphen werden die Netzknoten matrixförmig angeordnet, wobei sukzessive Spalten der matrixförmigen Anordnung von Netzknoten den sukzessiven Datenbytes (Bytesequenz) des zweiten Datenfiles zugeordnet werden. Hierbei ist es vorteilhaft, wenn innerhalb einer Spalte, verschiedene Zeilen den verschiedenen Zuständen eines selben Datenbytes des zweiten Datenfiles zugeordnet werden.

Vorteilhaft wird zur Ermittlung eines kostenoptimierten Pfads durch den Graphen jedem Netzknoten ein Kostenwert zugewiesen, welcher ungleich Null ist, wenn der dem Netzknoten zugeordnete Zustand ein von Null verschiedenes Datenbyte im Delta-File erzeugt, und andernfalls Null ist, wenn der dem Netzknoten zugeordnete Zustand ein zu Null gleiches Datenbyte (Null-Datenbyte) im Delta-File erzeugt. Ferner wird jeder Netzkante vorteilhaft ein Kostenwert zugewiesen, welcher Null ist, wenn die durch eine Netzkante verbundenen Netzknoten zu gleichen oder kompatiblen Pseudo-Matches gehören, und andernfalls ungleich Null ist, wenn die durch eine Netzkante verbundenen Netzknoten zu verschiedenen Pseudo-Matches gehören, also beispielsweise ein neuer DIFF- oder ADD-Befehl nötig wird.

Ist der Graph in der dargestellten Weise erstellt, wird ein kostenoptimierter Pfad im Graphen ermittelt, welcher die Summe aus der Anzahl der Nicht-Null-Bytes und Kosten der Datenverarbeitungsschritte, wie ADD- und DIFF-Operationen, minimiert. Ein zulässiger Pfad darf hierbei für alle Datenbytes des zweiten Datenfiles nur einen Netzknoten pro Datenbyte enthalten.

Aus dem ermittelten kostenoptimierten Pfad wird ein Delta-File generiert, welcher eine der sukzessiven Folge von Datenbytes des zweiten Datenfiles entsprechende Abfolge von den Netzknoten des kostenoptimierten Pfads zugeordneten Datenverarbeitungsschritten, wie ADD- oder DIFF-Operationen, enthält.

Durch das erfindungsgemäße Verfahren kann somit ein auf Pseudo-Matches basierender größenoptimierter Delta-File zur Generierung eines zweiten Datenfiles aus einem ersten Datenfile erzeugt werden. Durch den größenoptimierten Delta-File können Übertragungszeit und -Kosten für den Delta-File in vorteilhafter Weise vermindert werden. Das erfindungsgemäße Verfahren eignet sich demnach insbesondere für die Erzeugung von Delta-Files zur Übertragung mithilfe von Schnittstellen, welche über eine geringe Datenübertragungsrate verfügen und/oder hohe Datenübertragungskosten verursachen.

Bei einer weiteren vorteilhaften Ausgestaltung des erfindungsgemäßen Verfahrens kann die Erzeugung der Pseudo-Matches in der Weise erfolgen, dass zunächst eine Menge von in den beiden Datenfiles in exakter Übereinstimmung vorhandenen Teildatenbereichen ("Matches") ermittelt wird. Hierbei handelt es sich vorteilhaft um maximale Matches mit maximaler Länge. Anschließend werden jene Matches ermittelt, deren Positionen im ersten und im zweiten Datenfile jeweils um den gleichen Betrag differieren, so genannte "kompatible Matches", und Pseudo-Matches jeweils durch Zusammenfassen mehrerer kompatibler Matches zu einem einzelnen zusammenhängenden Datenbereich erzeugt.

Bei einer weiteren vorteilhaften Ausgestaltung des erfindungsgemäßen Verfahrens kann eine Verkleinerung von Pseudo-Matches auf Basis eines Kostenvergleichs von Kosten, welche auftreten, wenn ein Match innerhalb der Lücke eines Pseudo-Matches verwendet oder ignoriert wird, erfolgen.

Bei einer weiteren vorteilhaften Ausgestaltung des erfindungsgemäßen Verfahrens wird aus den Pseudo-Matches eine Menge nicht-überlappender Pseudo-Matches erzeugt, welche die Überdeckung des zweiten Datenfiles mit exakten Matches maximiert.

Die Erfindung erstreckt sich ferner auf einen maschinenlesbaren Programmcode (Computerprogramm) für eine elektronische Datenverarbeitungseinrichtung, welcher Steuerbefehle enthält, die die elektronische Datenverarbeitungseinrichtung zur Durchführung eines wie oben beschriebenen, erfindungsgemäßen Verfahrens veranlassen.

Darüber hinaus erstreckt sich die Erfindung auf ein Speichermedium (Computerprogrammprodukt) mit einem darauf gespeicherten maschinenlesbaren Programmcode für eine elektronische Datenverarbeitungseinrichtung, welcher Steuerbefehle enthält, die die elektronische Datenverarbeitungseinrichtung zur Durchführung des oben beschriebenen, erfindungsgemäßen Verfahrens veranlassen.

Die Erfindung wird nun anhand eines Ausführungsbeispiels näher erläutert, wobei Bezug auf die beigefügten Figuren genommen wird.
- Fig. 1: zeigt in einer schematischen Darstellung exakt übereinstimmende Teildatenstrings (Matches) zweier Datenfiles.
- Fig. 2: zeigt in einer schematischen Darstellung einen Graphen des erfindungsgemäßen Verfahrens, in dem Zustände von Daten-Bytes als Netzknoten modelliert sind.

Fig. 1 wurde bereits eingangs beschrieben, weshalb sich eine nähere Erläuterung hier erübrigt.

Gemäß dem dargestellten und erläuterten Ausführungsbeispiel besteht das erfindungsgemäße Verfahren aus mehreren Schritten, die nun im Einzelnen erläutert werden:

In dem Ausführungsbeispiel soll ein auf Pseudo-Matches basierender Delta-File generiert werden, mithilfe dessen ein zweiter Datenfile aus einem ersten Datenfile erzeugt werden kann. Der zweite Datenfile kann hierbei ein Datenfile zum Updaten oder Upgraden des ersten Datenfiles sein.

### Schritt 1: Ermittlung exakter Matches

In Schritt 1 wird zunächst der zweite Datenfile mit einer Folge von maximalen exakten Matches, das heißt vollständig übereinstimmenden Datenbereichen der beiden Datenfiles, welche eine maximale Datenlänge aufweisen, möglichst vollständig überdeckt.

Zum schnellen Auffinden solcher exakten Matches kann beispielsweise ein Verfahren verwendet werden, welches in U. Manber, E. W. Myers, "Suffix arrays: a new method for online string searches", SIAM J. Comput. 22(5), 1993, Seiten 935-948, beschrieben ist.

Demnach wird aus dem ersten Datenfile zunächst eine Anordnung von Teildatenstrings, ein so genanntes "Suffix-Array", nämlich eine sortierte Menge, welche alle Suffixes (Teildatenstrings) eines Datenstrings enthält, ermittelt.

Beispielsweise enthält der Datenstring "foo" die Suffixes "foo", "OO" und "O". Das Suffix-Array wird als ein Array von sortierten Indizes der Substrings gespeichert, im vorliegenden Beispiel (0, 2, 1) für "foo", "O" und "OO".

Zum Aufbau eines Suffix-Arrays und zur Suche von maximal matchenden Teildatenstrings sind effiziente Algorithmen im Stand der Technik verfügbar und dem Fachmann als solche bekannt.

Ist eine Suffix-Array erstellt, so wird der zweite Datenfile von Anfang bis Ende durchlaufen, wobei (exakte) Matches erkannt und in einer Liste gespeichert werden. Dieser Schritt kann beispielsweise durch den folgenden Pseudo-Code beschrieben werden:

```
     build suffix array SA from old file;
     List matches;
     int new_size = length of new file;
     int scan = 0;
     while (scan < new_size) {
        (pos0, length) = find_maximum_match (SA,scan);
        if (length > 0) {
          matches.append(new Match(pos0, scan, length));
           scan+=length;
        }
        else scan++;
     }
```

Die Prozedur find_maximum_match sucht nach einem maximalen Match (exakt übereinstimmenden Teildatenbereich) im ersten Datenfile bezüglich des Teildatenstrings, der auf der Position scan im zweiten Datenfile beginnt. Sie gibt die Position im ersten Datenfile und die Länge der Übereinstimmung zurück. Im Erfolgsfall (Länge > 0) wird der Match in der Liste der Matches gespeichert und im zweiten Datenfile kann die entsprechende Länge übersprungen werden. Andernfalls wird die scan-Position um das Inkrement 1 erhöht. Folgen solcher nicht-matchender Schritte entsprechen den Lücken in Fig. 1.

Zu diesem Algorithmus können beispielsweise zwei Modifikationen durchgeführt werden:

### Modifikation 1:

Wenn ein Match M1 gefunden wird, der unmittelbar (das heißt ohne Lücke) auf einen vorausgehenden Match M0 folgt, wird geprüft, ob M1 rückwärts ausgedehnt werden kann, da die Position "scan-1" im vorangegangenen Schleifendurchlauf nicht untersucht wurde. Ist dies der Fall, und ist das resultierende M1 länger als das entsprechend reduzierte M1, dann ist es vorteilhaft, wenn diese Modifikation durchgeführt wird, da längere Matches zu bevorzugen sind.

### Modifikation 2:

Wenn die Länge eines Matches unterhalb einer vorgegebenen Schranke liegt, wird geprüft, ob ein Löschen dieses Matches die Kosten erhöhen würde: falls nein, wird dieser Match gelöscht, um das Speichern einer hohen Anzahl kleiner nutzloser Matches zu vermeiden; falls ja, wird dieser Match nicht gelöscht. Als "Kosten" wird hier der Beitrag zur Länge des komprimierten Delta-Files angesehen. Diese wird näherungsweise bestimmt durch die Anzahl der Nicht-Null-Bytes im Delta-File plus Kostenanteile für die einzelnen COPY-, ADD- and DIFF-Befehle.

### Schritt 2: Erzeugung von Pseudo-Matches

In Schritt 2 werden Pseudo-Matches aus den in Schritt 1 ermittelten (exakten) Matches generiert. Hierbei werden kompatible exakte Matches jeweils zu einem Pseudo-Match zusammengefasst, wobei als kompatible exakte Matches solche exakten Matches betrachtet werden, deren Positionen ("pos0") im ersten Datenfile und deren Positionen ("pos1") im zweiten Datenfile um den gleichen Betrag differieren. (In Fig. 1 betrachtet, haben kompatible exakte Matches zueinander parallele Pfeile.) Wenn die Differenz des zweiten Datenfiles zu dem ersten Datenfile gebildet wird, kann lediglich die Lücke zwischen den kompatiblen exakten Matches Nicht-Null-Bytes erzeugen. Anders ausgedrückt, es sind alle exakten Matches kompatibel, für die die Differenz (pos1-pos0) den gleichen Wert hat.

Um die Pseudo-Matches zu erzeugen, werden alle exakten Matches nach dieser Differenz (pos1-pos0) sortiert, wobei eine Folge von Bündeln mit gleicher Differenz erhalten wird. Jedes dieser Bündel entspricht einem Pseudo-Match.

Bei dieser Vorgehensweise gehört jeder exakte Match genau zu einem Pseudo-Match. Pseudo-Matches können sich gegenseitig überlappen, wobei ein exakter Match der kompatiblen exakten Matches eines Pseudo-Matches in die Lücke der kompatiblen exakten Matches eines anderen Pseudo-Matches fällt.

### Schritt 3: Aufspalten von Pseudo-Matches

Die in Schritt 2 durch Zusammenfassen von kompatiblen exakten Matches erzeugten Pseudo-Matches können mitunter sehr lang sein, und demnach große (nur teuer zu schließende) Lücken enthalten. Es wird daher in Schritt 3 jede Lücke innerhalb eines Pseudo-Matches und die Matches (aus anderen Pseudo-Matches) innerhalb dieser Lücke untersucht. Hierbei werden die Kosten verglichen, die entstehen, wenn das Match innerhalb der Lücke eines Pseudo-Matches verwendet wird (dabei entstehen zwei DIFF-Befehle) und die Kosten, die auftreten, wenn es ignoriert wird (dabei entstehen zusätzliche Nicht-Null-Bytes im Delta-File). Für den Fall, dass erstgenannte Kosten niedriger sind, wird der Pseudo-Match aufgeteilt; für den Fall dass zweitgenannte Kosten niedriger sind, wird der Pseudo-Match nicht aufgeteilt.

### Schritt 4: Auswahl von Pseudo-Match-Kandidaten

In Schritt 4 wird eine Menge viel versprechender Pseudo-Matches für Schritt 5 des Verfahrens ausgesucht. Hierbei wird aus der Menge aller (im Allgemeinen) überlappender Pseudo-Matches eine nicht-überlappende Teilmenge (oder Kette) von Pseudo-Matches bestimmt, die die Überdeckung des zweiten Datenfiles mit exakten Matches maximiert oder - äquivalent hierzu - die Länge der Lücken minimiert.

Hierzu wird von der Tatsache ausgegangen, dass in einer optimalen Kette cₙ von n Pseudo-Matches p₁, p₂, ...pₙ jede Teilkette cᵢ von i Pseudo-Matches p₁, p₂, ...pᵢ ebenfalls eine optimale Teilkette sein muss. Daher kann die optimale Kette cₙ als Erweiterung einer optimalen Teilkette cₙ₋₁ gefunden werden.

Hieraus ergibt sich ein dynamisches Programm für die Bestimmung der optimalen Kette, das leicht durch einen Durchlauf von links nach rechts über die Pseudo-Matches realisiert werden kann, wenn man zunächst die Pseudo-Matches nach ihren linken und rechten Enden sortiert und in jedem Pseudo-Match die Überdeckung einer optimalen Kette speichert, die mit diesem Pseudo-Match endet.

Im folgenden beispielhaften Pseudo-Code ist "cover(g)" die Anzahl matchender Bytes eines Pseudo-Matches "g", also die Gesamtlänge der exakten Matches, aus denen der Pseudo-Match besteht; "total_cover(g)" ist die Gesamtlänge der Matches einer Kette von Pseudo-Matches, deren Element g ist.

```
     List starting;
     List ending;
     add all Pseudo-Matches to lists starting and ending;
     sort list starting by left end;
     sort list ending by right end;
     Pseudo*e = ending.first();
     pseudo*best_ending = 0;
     int best_cover = 0;
     for all pseudos s sorted by left end {
       // maintain best group e ending before s:
          while (right end of e < left end of s) {
               if (total_cover(e) > best_cover) {
                   best_cover = total_cover(e);
                   best_ending = e;
               }
               e = successor of e in list ending_groups;
          }
          pred(s) = best_ending; // let s point to
                        best_ending
          total_cover(s) = cover(s) +
                             total_cover(best_ending);
     }
```

Es kann nunmehr der Pseudo-Match mit maximalem Wert "total_cover" gesucht werden, wobei den Rückwärtszeigern "pred" gefolgt wird, um so die ganze optimale Kette zu durchlaufen.

### Schritt 5: Zuordnung der Bytes des zweiten Datenfiles zu Pseudo-Match-Kandidaten

Dies ist der Hauptoptimierungsschritt des erfindungsgemäßen Verfahrens. Hierbei wird für jedes Byte des zweiten Datenfiles entschieden, ob es einem Pseudo-Match zugeordnet wird und falls ja, welchem.

Für den Fall, dass ein Byte des zweiten Datenfiles einem Pseudo-Match zugeordnet wird, wird es Teil einer DIFF-Operation und die Differenz zwischen dem Wert dieses Bytes und dem Wert des entsprechenden Bytes im ersten Datenfile wird gespeichert. Für den alternativen Fall, dass ein Byte des zweiten Datenfiles einem Pseudo-Match nicht zugeordnet wird, wird es Teil einer ADD-Operation und sein Wert wird gespeichert.

Falls das einem Pseudo-Match zugeordnete Byte zu den exakt übereinstimmenden Datenbereichen des Pseudo-Matches gehört, ist die Differenz Null; andernfalls ist die Differenz nicht Null. Bei Elementen der ADD-Operationen kann die Differenz von Null verschieden sein. Ziel einer Optimierung ist es, die Anzahl dieser von Null verschiedenen Bytes zu minimieren, da sie die Kompressibilität des resultierenden Delta-Files verringern.

Die Anzahl der Nicht-Null-Bytes ist jedoch nur ein Teil der Zielfunktion. Ein anderer Teil der Zielfunktion ist der Speicherbedarf für die DIFF- und ADD-Operationen, also für Operationscode, Positions- und Längenangaben. Ob für ein Byte ein neuer Befehl abgesetzt werden muss, hängt von den Entscheidungen für dieses Byte und das vorangehende Byte ab, das heißt, es muss der gesamte Kontext betrachtet werden.

In Schritt 5, dem Kern des erfindungsgemäßen Verfahrens, erfolgt die Entscheidung, ob und welchem Pseudo-Match ein Byte des zweiten Datenfiles zugeordnet wird, durch dynamische Programmierung, oder äquivalent, durch die Berechnung eines kürzesten (das heißt kostenoptimierten) Pfads in einem Graphen, welcher wie folgt modelliert wird.

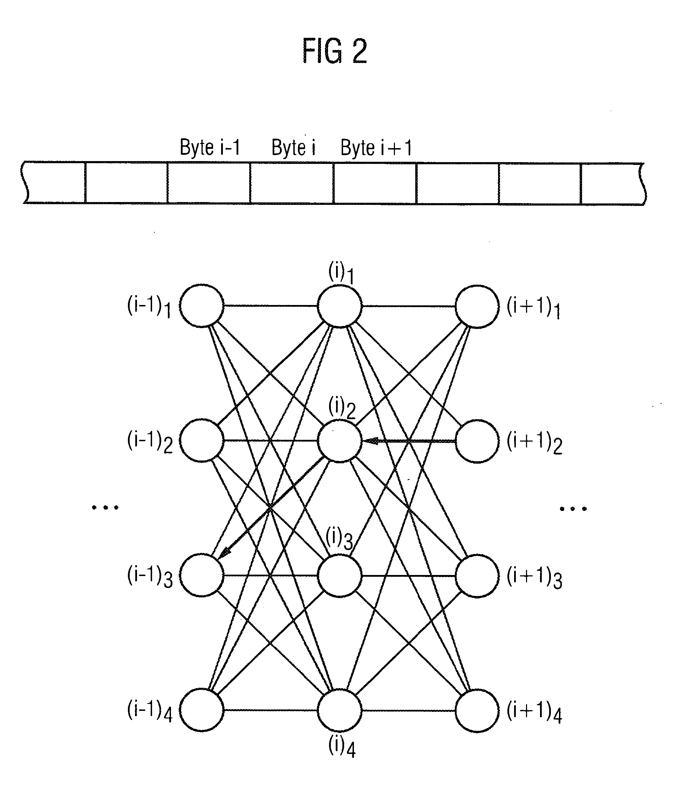

Es wird nun Bezug auf Fig. 2 genommen, worin in einer schematischen Darstellung ein Graph des dynamischen Programms des erfindungsgemäßen Verfahrens veranschaulicht ist. Zudem ist in Fig. 2 die sukzessive Folge von Bytes des zweiten Datenfiles dargestellt.

Zur Modellierung des Graphen von Fig. 2 werden die möglichen Zustände der Datenbytes der sukzessiven Folge von Datenbytes des zweiten Datenfiles als Netzknoten aufgefasst. Hierbei werden für jedes Byte des zweiten Datenfiles, wie in Fig. 2 beispielhaft für die sukzessiven Bytes (i-1), (i) und (i+1) dargestellt ist, k Netzknoten in den vertikalen Spalten des Graphen (in Fig. 2, k=4) angeordnet, welche jeweils den Zuständen eines jeweiligen Datenbytes des zweiten Datenfiles entsprechen. Dies sind für das Datenbyte (i-1) die Zustände (i-1) ₁, (i-1) ₂, (i-1), und (i-1) ₄, für das Datenbyte i die Zustände (i)₁, (i) ₂, (i)₃, und (i)₄, und für das Datenbyte (i+1) die Zustände (i+1)₁, (i+1)₂, (i+1)₃ und (i+1)₄.

Mögliche Zustände eines jeden Datenbytes des zweiten Datenfiles können sein: ein ADD-Befehl, welcher bewirkt, dass dieses Datenbyte aus dem Input (Delta-File beziehungsweise Datenfeld des ADD-Befehls) gelesen wird, und DIFF match 3-Befehle, welche jeweils bewirken, dass das Summen-Byte, summiert aus der Differenz dieses Datenbytes zu dem Datenbyte in der entsprechenden Position im ersten Datenfile, welche der Verwendung von Pseudo-Match j entspricht, und dem entsprechenden Datenbyte im ersten Datenfile gespeichert wird.

In dem Graphen wird jedem Netzknoten ein Kostenwert verschieden von Null, beispielsweise 1, oder Null zugeordnet, je nachdem ob dieser Zustand ein Nicht-Null-Byte oder ein Null-Byte im Delta-File erzeugt.

Zudem wird jeder einem Datenbyte zugeordneter Netzknoten des Graphen mit jedem dem unmittelbar vorhergehenden Datenbyte zugeordneten Netzknoten durch Netzwerkkanten verbunden. Den Netzwerkkanten wird ebenfalls ein Kostenwert zugeordnet, nämlich Null, wenn die beiden verbundenen Netzknoten zu gleichen oder kompatiblen Pseudo-Matches gehören und ungleich Null, beispielsweise 1, im anderen Fall, wenn eine neue Operation notwendig wird. Im letztgenannten Fall werden die Kosten dieser Operation eingetragen.

Für den erstellten Graphen mit zugeordneten Kostenwerten für Netzknoten und Netzkanten wird mittels eines Algorithmus ein kürzester (kostenoptimierter) Pfad im Graphen ermittelt.

Ein Pfad durch dieses Netzwerk, der genau einen Netzknoten aus jeder Spalte enthält, entspricht einer zulässigen Folge von DIFF- und ADD-Operationen, die alle Datenbytes abdeckt und somit einen korrekten Delta-File erzeugt. Der kürzeste Pfad aller solcher Pfade minimiert die Summe aus der Anzahl der Nicht-Null-Bytes und der Kosten der ADD- und DIFF-Befehle. Ein solcher kürzester (kostenoptimierter) Pfad im Graphen kann durch einen wie unten dargestellten Algorithmus zur Ermittlung eines kürzesten Pfads erfolgen.

Obwohl es kⁿ verschiedene Pfade für einen zweiten Datenfile der Länge n gibt, kann der kürzeste Pfad auf Grund der speziellen Struktur des Graphen in O(k²n) Schritten gefunden werden. Dies ist im folgenden Pseudo-Code beispielhaft dargestellt:

```
     for all positions i = 1 ... n of the new file {
          update set of candidate matches;
          allocate one node per candidate;
          for all nodes v at current position {
               int best_cost = ∞;
               for all nodes w at previous position {
                 cost_w_v = total_cost(w) + cost(w,v) + cost
     (v);
                 if (cost_w_v) < best_cost) {
                   best_cost = cost_v_w;
                   best_pred = w;
                 }
          }
     pred(v) = best_pred;
     total_cost(v) =best_cost;
  }
 }
```

Nachdem alle Positionen bearbeitet wurden (Hauptschleife im obigen Pseudo-Code), wird aus der letzten Spalte der Netzknoten mit dem kleinsten Wert "total_cost" gewählt und den "pred-Zeigern" (in Fig. 2 fett eingezeichnet) rückwärts gefolgt, um den kürzesten (billigsten) Pfad zu identifizieren. Anschließend werden entsprechend den Byte-Zuordnungen längs dieses Pfads die ADD- und DIFF-Operationen des Delta-Files erzeugt.

Im Weiteren werden weitere Modifikationen des erfindungsgemäßen Verfahrens beschrieben:

### Modifikation 3: Menge der Pseudo-Match-Kandidaten und ihre Pflege

Da der Zustand eines Netzknotens der Zuordnung des betreffenden Datenbytes zu einem Pseudo-Match entspricht, ist es vorteilhaft, eine Menge geeigneter Pseudo-Matches bereit zu halten und beim Durchlaufen obigen Pseudo-Code zu pflegen. Hierzu wird in diese Menge zum einen der Pseudo-Match aus der in Schritt 4 "Auswahl von Pseudo-Match-Kandidaten" berechneten Kette aufgenommen, der die aktuelle Position überdeckt; zum anderen wird eine vorgebbare Anzahl von Matches aus der Umgebung der aktuellen Position aufgenommen. Beim Übergang zu einer neuen Position wird diese Menge aktualisiert, das heißt, zurück liegende Elemente verlassen die Menge und voraus liegende Matches werden eingefügt.

### Modifikation 4: Reduktion des Speicherbedarfs des Verfahrens

Wird das Verfahren so wie beschrieben implementiert, müssen k x n Netzknoten gespeichert werden, von denen jeder die akkumulierten Kosten des besten Pfads durch diesen Netzknoten, den Zeiger auf den Vorgänger-Netzknoten im besten Pfad und einen Zeiger auf den zugehörigen Match enthält. Dies sind 12k Datenbytes pro Input-Datenbyte und daher für große Input-Files vergleichsweise viel. Hinzu kommt noch der Speicherbedarf für k²n Kanten. Dies kann durch vier Modifikationen des Grundalgorithmus vermieden werden:

### Modifikation 4.1:

Das "total_cost"-Feld wird nur in den Netzknoten der aktuellen und der vorausgehenden Spalte benötigt. Es werden daher zwei Knotentypen verwendet, ein großer Knotentyp mit einem "total_cost"-Feld für diese speziellen Spalten und einen kleinen Knotentyp für "alte" Spalten.

### Modifikation 4.2:

Es wird die Anzahl der kürzesten Pfade gespeichert, zu denen ein Netzknoten gehört, also die Anzahl eingehender fetter Kanten, wie in Fig. 2 dargestellt ist. Wenn nach Bearbeitung von Spalte i dieser Wert für einen Netzknoten in Spalte (i-1) Null ist, so kann dieser gelöscht werden. Dabei wird im Vorgänger-Netzknoten dieser Wert dekrementiert und gegebenenfalls dieser Netzknoten ebenfalls gelöscht, und so weiter.

### Modifikation 4.3:

Es wird in den Netzknoten ein Längenfeld eingeführt, das zunächst den Kostenwert 1 erhält. Wenn ein aktueller Knoten "u" und sein Vorgänger-Netzknoten "v" sich auf den gleichen (oder zwei kompatible) Match(es) beziehen, lässt man den "pred"-Zeiger von "u" auf "pred(v)" zeigen, reduziert die Anzahl kürzester Pfade in "v" um 1 und erhöht die Länge in "u" um die Länge von "v". Anschließend können "v" und der Vorgänger möglicher Weise gelöscht werden. Ein Knoten repräsentiert jetzt nicht mehr ein einzelnes Datenbyte, sondern eine Folge von Datenbytes, die gleich behandelt werden, also einen Pseudo-Match. Dies reduziert den Speicherbedarf dramatisch.

### Modifikation 4.4:

Kanten werden nicht gespeichert, sondern ihre Kostenwerte werden "on-the-fly" ermittelt, wenn sie benötigt werden.

## Patentansprüche

1. Verfahren zur Erzeugung eines die Differenz zwischen einem ersten Datenfile und einem zweiten Datenfile kodierenden Delta-Files, bei welchem Verfahren eine Menge von in den beiden Datenfiles in teilweiser Übereinstimmung vorhandenen Teildatenstrings ("Pseudo-Matches") bestimmt und ein Graph modelliert wird, bei dem jeder Netzknoten einen auf dem ersten Datenfile basierenden Datenverarbeitungsschritt zur Erzeugung eines Datenbytes des zweiten Datenfiles repräsentiert, wobei in dem Graphen jeder einem Datenbyte des zweiten Datenfiles zugeordnete Netzknoten mit allen Netzknoten, welche einem unmittelbar vorangehenden Datenbyte des zweiten Datenfiles zugeordnet sind, durch Netzkanten verbunden wird, und den Netzknoten und Netzkanten jeweils ein Kostenwert zugewiesen wird, bei welchem Verfahren ein kostenoptimierter Pfad im Graphen ermittelt wird, welcher für alle Datenbytes des zweiten Datenfiles nur einen Netzknoten pro Datenbyte enthält, und auf Basis des kostenoptimierten Pfads ein Delta-File generiert wird, welcher eine der sukzessiven Folge von Netzknoten im kostenoptimierten Pfad entsprechende Abfolge von Datenverarbeitungsschritten und deren Datenfelder enthält.

2. Verfahren nach Anspruch 1, bei welchem die auf dem ersten Datenfile basierenden Datenverarbeitungsschritte zur Erzeugung eines Datenbytes des zweiten Datenfiles jeweils auf ein Pseudo-Match bezogen sind.

3. Verfahren nach Anspruch 2, bei welchem die auf dem ersten Datenfile basierenden Datenverarbeitungsschritte zur Erzeugung eines Datenbytes des zweiten Datenfiles ADD-Operationen und Diff-Operationen umfassen, wobei durch eine ADD-Operation das Lesen eines dieser ADD-Operation zugeordneten Datenfeldes aus dem Delta-File und dessen Speichern an einer Position im zweiten Datenfile, welche der Position des Datenbytes entspricht, dem die ADD-Operation zugeordnet ist, bewirkt wird, und wobei durch eine auf ein Pseudo-Match bezogene DIFF-Operation ein Speichern eines Summen-Datenbytes, summiert aus einem Datenfeld der DIFF-Operation und einem entsprechenden Datenbyte des Pseudo-Matches des ersten Datenfiles, an einer Position im zweiten Datenfile, welche der Position des Datenbytes entspricht, dem die DIFF-Operation zugeordnet ist, bewirkt wird.

4. Verfahren nach einem der Ansprüche 1 bis 3, bei welchem ein Zeilen und Spalten umfassender matrizenförmiger Graph modelliert wird, wobei sukzessive Spalten des Graphen den sukzessiven Datenbytes des zweiten Datenfiles zugeordnet werden.

5. Verfahren nach einem der Ansprüche 1 bis 4, bei welchem jedem Netzknoten ein Kostenwert zugewiesen wird, welcher ungleich Null ist, wenn der dem Netzknoten zugeordnete Zustand ein von Null verschiedenes Datenbyte im Delta-File erzeugt und Null ist, wenn der dem Netzknoten zugeordnete Zustand ein zu Null gleiches Datenbyte im Delta-File erzeugt.

6. Verfahren nach einem der Ansprüche 1 bis 5, bei welchem jeder Netzkante ein Kostenwert zugewiesen wird, welcher Null ist, wenn die durch eine Netzkante verbundenen Netzknoten zu gleichen oder kompatiblen Pseudo-Matches gehören, und ungleich Null ist, wenn die durch eine Netzkante verbundenen Netzknoten zu verschiedenen Pseudo-Matches gehören.

7. Verfahren nach einem der Ansprüche 1 bis 6, bei welchem die Erzeugung der Pseudo-Matches die folgenden Schritte umfasst:
- Erzeugen einer Menge von in den beiden Datenfiles vorhandenen, insbesondere maximalen, exakt übereinstimmenden Teildatenbereichen ("Matches");
- Ermitteln von Matches deren Positionen im ersten und im zweiten Datenfile jeweils um den gleichen Betrag differieren ("kompatible Matches");
- Erzeugen von Pseudo-Matches jeweils durch Zusammenfassen von mehreren kompatiblen Matches zu einem zusammenhängenden Datenbereich.

8. Verfahren nach einem der Ansprüche 1 bis 7, bei welchem eine Verkleinerung von Pseudo-Matches auf Basis eines Kostenvergleichs von Kosten, welche auftreten, wenn ein Match innerhalb der Lücke eines Pseudo-Matches verwendet oder ignoriert wird, erfolgt.

9. Verfahren nach einem der Ansprüche 1 bis 8, bei welchem aus den Pseudo-Matches eine Menge nicht-überlappender Pseudo-Matches, welche die Überdeckung des zweiten Datenfiles mit exakten Matches maximiert, gewählt wird.

10. Verfahren nach einem der Ansprüche 1 bis 9, bei welchem der Delta-File komprimiert wird.

11. Maschinenlesbarer Programmcode für eine elektronische Datenverarbeitungseinrichtung, welcher Steuerbefehle enthält, die die elektronische Datenverarbeitungseinrichtung zur Durchführung eines Verfahrens nach einem der Ansprüche 1 bis 10 veranlassen.

12. Speichermedium mit einem darauf gespeicherten maschinenlesbaren Programmcode gemäß Anspruch 11.

## Claims

1. Method for producing a delta-file encoding the difference between a first data file and a second data file, in which method a set of elemental data strings ("pseudo-matches") which are present in the two data files in a partial match is determined and a graph is modelled, in which each network node represents a data processing step based on the first data file for producing a data byte of the second data file, each network node associated with a data byte of the second data file in the graph being connected by network edges to all network nodes which are associated with a directly preceding data byte of the second data file, and the network nodes and network edges are respectively assigned a cost value, which method involves a cost-optimised path in the graph being ascertained which, for all data bytes of the second data file, contains only one network node per data byte, and the cost-optimised path being taken as a basis for generating a delta-file which contains a series of data processing steps and their data fields which corresponds to the successive sequence of network nodes in the cost-optimised path.

2. Method according to claim 1, in which the data processing steps based on the first data file for producing a data byte of the second data file are respectively specific to a pseudo-match.

3. Method according to claim 2, in which the data processing steps based on the first data file for producing a data byte of the second data file comprise ADD-operations and Diff-operations, the reading of a data field associated with this ADD-operation from the delta-file being effected by an ADD-operation and the storage thereof being effected at a position in the second data file which corresponds to the position of the data byte with which the ADD-operation is associated, and a data byte sum, totalled from a data field of the DIFF-operation and a corresponding data byte of the pseudo-match of the first data file, being stored by a DIFF-operation specific to a pseudo-match at a position in the second data file which corresponds to the position of the data byte to which the DIFF-operation is assigned.

4. Method according to one of claims 1 to 3, in which a graph is modelled in the form of a matrix comprising lines and columns, successive columns of the graph being assigned to the successive data bytes of the second data file.

5. Method according to one of claims 1 to 4, in which a cost value is assigned to each network node which is not equal to zero if the state associated with the network node produces a data byte in the delta-file which is different from zero and is zero if the state associated with the network node produces a data byte in the delta-file equal to zero.

6. Method according to one of claims 1 to 5, in which a cost value is assigned to each network edge, which is zero if the network nodes connected by a network edge belong to the same or compatible pseudo-matches, and is not equal to zero if the network nodes connected by a network edge belong to different pseudo-matches.

7. Method according to one of claims 1 to 6, in which the production of pseudo-matches comprises the following steps:
- production of a set of exactly matching, in particular maximum, elemental data regions ("matches") present in the two data files;
- ascertaining matches, the positions thereof respectively differing in the first and in the second data file by the same amount ("compatible matches");
- producing pseudo-matches by respectively combining a plurality of compatible matches to form a combined data region.

8. Method according to one of claims 1 to 7, in which a reduction of pseudo-matches takes place, based on a cost comparison of costs, which occur if a match is used or not known within the gap of a pseudo-match.

9. Method according to one of claims 1 to 8, in which a set of non-overlapping pseudo-matches is selected from the pseudo-matches, which maximises the overlapping of the second data file by exact matches.

10. Method according to one of claims 1 to 9, in which the delta-file is compressed.

11. Machine-readable program code for an electronic data processing device, which contains control commands, which cause the electronic data processing device to carry out a method according to one of claims 1 to 10.

12. Storage medium with a machine-readable program code stored therein according to claim 11.

## Revendications

1. Procédé pour générer un fichier delta codant la différence entre un premier fichier de données et un second fichier de données, dans lequel une quantité de chaînes de données partielles ("Pseudo-Matches") présentes dans les deux fichiers de données dans une concordance partielle est déterminée et un graphe est modélisé, dans lequel chaque noeud de réseau représente une étape de traitement de données basée sur le premier fichier de données pour générer un byte de données du second fichier de données, chaque noeud de réseau attribué à un byte de données du second fichier de données étant relié dans le graphe par des arêtes de réseau à tous les noeuds de réseau qui sont attribués à un byte de données directement précédent du second fichier de données, et à chaque fois une valeur de coût étant attribuée aux noeuds de réseau et aux arêtes de réseau, procédé dans lequel un chemin optimisé au niveau du coût est déterminé dans le graphe, qui contient pour tous les bytes de données du second fichier de données uniquement un noeud de réseau par byte de données, et un fichier delta est généré sur la base du chemin optimisé au niveau du coût, lequel fichier contient une succession, correspondant à la séquence successive de noeuds de réseau dans le chemin optimisé au niveau du coût, d'étapes de traitement de données et leurs champs de données.

2. Procédé selon la revendication 1, dans lequel les étapes de traitement de données basées sur le premier fichier de données pour la génération d'un byte de données du second fichier de données sont rapportées à chaque fois à un Pseudo-Match.

3. Procédé selon la revendication 2, dans lequel les étapes de traitement de données basées sur le premier fichier de données pour la génération d'un byte de données du second fichier de données comprennent des opérations ADD et des opérations Diff, dans lequel, par une opération ADD, on obtient la lecture d'un champ de données attribué à cette opération ADD, à partir du fichier delta et de son stockage sur une position dans le second fichier de données, qui correspond à la position du byte de données auquel l'opération ADD est attribuée, et dans lequel on obtient, par une opération DIFF rapportée à un Pseudo-Match, un stockage d'un byte de données cumulé, cumulé à partir d'un champ de données de l'opération DIFF et d'un byte de données correspondant du Pseudo-Match du premier fichier de données, sur une position dans le second fichier de données, qui correspond à la position du byte de données auquel l'opération DIFF est attribuée.

4. Procédé selon l'une quelconque des revendications 1 à 3, dans lequel un graphe sous forme de matrice comprenant des lignes et des colonnes est modélisé, des colonnes successives du graphe étant attribuées aux bytes de données successifs du second fichier de données.

5. Procédé selon l'une quelconque des revendications 1 à 4, dans lequel à chaque noeud de réseau est attribuée une valeur de coût qui est différente de zéro lorsque l'état attribué au noeud de réseau génère un byte de données différent de zéro dans le fichier delta et est zéro lorsque l'état attribué au noeud de réseau génère un byte de données égal à zéro dans le fichier delta.

6. Procédé selon l'une quelconque des revendications 1 à 5, dans lequel à chaque arrête de réseau est attribuée une valeur de coût qui est zéro lorsque les noeuds de réseau reliés par une arête de réseau appartiennent à des Pseudo-Matches identiques ou compatibles, et différente de zéro lorsque les noeuds de réseau reliés par une arête de réseau appartiennent à différents Pseudo-Matches.

7. Procédé selon l'une quelconque des revendications 1 à 6, dans lequel la génération de Pseudo-Matches comprend les étapes suivantes :
- génération d'une quantité de zones de données partielles ("Matches") présentes dans les deux fichiers de données, en particulier maximales, et concordant exactement ;
- détermination de Matches dont les positions dans le premier et le second fichier de données diffèrent à chaque fois du même montant ("Matches compatibles") ;
- génération de Pseudo-Matches à chaque fois par regroupement de plusieurs Matches compatibles en une zone de données cohérente.

8. Procédé selon l'une quelconque des revendications 1 à 7, dans lequel une réduction de Pseudo-Matches a lieu sur la base d'une comparaison de coûts qui apparaissent lorsqu'un Match est utilisé ou ignoré à l'intérieur du vide d'un Pseudo-Match.

9. Procédé selon l'une quelconque des revendications 1 à 8, dans lequel une quantité de Pseudo-Matches sans superposition, qui maximise le recouvrement du second fichier de données avec des Matches exacts, est choisie à partir des Pseudo-Matches.

10. Procédé selon l'une quelconque des revendications 1 à 9, dans lequel le fichier delta est comprimé.

11. Code de programme lisible par machine pour un dispositif électronique de traitement de données, qui contient des instructions de commande qui ordonnent au dispositif électronique de traitement de données la mise en oeuvre d'un procédé selon l'une quelconque des revendications 1 à 10.

12. Support de stockage comprenant un code de programme lisible par machine et stocké dessus selon la revendication 11.
